(19) Europäisches Patentamt / European Patent Office / Office européen des brevets

(11) **EP 3 340 281 A1**

(12) **DEMANDE DE BREVET EUROPEEN**

(43) Date de publication:
**27.06.2018 Bulletin 2018/26**

(51) Int Cl.:
*H01L 21/02* [(2006.01)]     *H01L 29/16* [(2006.01)]
*C01B 32/186* [(2017.01)]     *C01B 32/188* [(2017.01)]

(21) Numéro de dépôt: **17209123.3**

(22) Date de dépôt: **20.12.2017**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD TN**

(30) Priorité: **22.12.2016  FR 1663198**

(71) Demandeur: **Commissariat à l'Energie Atomique et aux Energies Alternatives**
**75015 Paris (FR)**

(72) Inventeurs:
• **GOLANSKI, Luana**
  **38610 GIERES (FR)**
• **FOURNEL, Frank**
  **38910 VILLARD-BONNOT (FR)**
• **FUGIER, Pascal**
  **38190 BERNIN (FR)**
• **RODRIGUEZ, Guillaume**
  **38190 LE CHAMP PRES FROGES (FR)**

(74) Mandataire: **Nony**
**11 rue Saint-Georges**
**75009 Paris (FR)**

(54) **PROCEDE DE PRODUCTION D'UN FILM DE GRAPHENE**

(57)     Procédé de production d'un film de graphène, comportant les étapes consistant à disposer d'un substrat comportant une couche de catalyse en contact avec un support autoporteur électriquement isolant, la couche de catalyse comportant une zone monocristalline de catalyse contenant en masse plus de 99,9% de platine ou plus de 99,9% en masse d'un alliage de platine comportant en masse plus de 50,0 % de platine, le support comportant une zone monocristalline électriquement isolante contenant en masse plus de 99,9% d'un oxyde choisi parmi $MgO$, $GeO_2$, $\alpha-Al_2O_3$, $Pr_2O_3$, $\alpha-Fe_2O_3$, $TiO_2$, $BaTiO_3$, $CeO_2$, $ZrO_2$, $HfO_2$, $Ta_2O_5$, $SrO$, $BaZrO_3$, $SrZrO_3$, $LaAlO_3$, $YAlO_3$, $PrSeO_3$, $CaO$, $Se_2O_3$, $BaO$, $Lu_2O_3$, $La_2O_3$, $LaScO_3$, $GdSc_2O_3$, $Sc_2O_3$, $Y_2O_3$, $SrZrO_3$, $Y_3Al_5O_{12}$, $MgAl_2O_4$ et leurs mélanges, la zone monocristalline de catalyse étant épitaxiée sur la zone monocristalline électriquement isolante, la zone monocristalline électriquement isolante présentant une épaisseur supérieure à 0,1 mm, la face de la zone monocristalline de catalyse présentant une rugosité inférieure à 5,0 nm, puis former un film de graphène par dépôt épitaxial au contact de la zone monocristalline de catalyse dudit substrat.

Fig. 1

**EP 3 340 281 A1**

# Description

La présente invention concerne un procédé de fabrication d'un film de graphène par dépôt chimique en phase vapeur sur un catalyseur à base de platine formé sur un substrat massif, le film de graphène étant destiné à des applications dans les domaines de la nanoélectronique, des cellules photovoltaïques et des capteurs biologiques.

Pour de telles applications, un film de graphène est généralement disposé sur un support électriquement isolant. Par exemple, à cet effet, il est connu de former un film de graphène par dépôt en voie chimique en phase vapeur sur un substrat oxyde massif monocristallin, par exemple comprenant du saphir recouvert d'un alliage à base de métaux tels que le nickel, le fer, le ruthénium, le cobalt et le cuivre, comme par exemple décrit dans CN 104045079 A1, puis de transférer et coller le film de graphène ainsi formé sur une couche de silice amorphe recouvrant un support de silicium. Il est aussi connu d'obtenir un film de graphène par exfoliation présentant d'excellentes mobilités électriques. Cependant, l'exfoliation de graphène ne permet pas de produire des films de graphène à l'échelle industrielle avec une bonne reproductibilité. Le film est polycristallin et la connexion entre les grains et difficile à contrôler. En outre, les films du graphène d'épaisseurs contrôlés et d'une taille supérieure à 100 mm sont difficiles à produire.

Il est par ailleurs décrit dans US 2013/0288464 A1 le dépôt d'un film de graphène par dépôt chimique en phase vapeur (ou «CVD » en anglais, acronyme de Chemical Vapor Déposition) sur une couche métallique disposée sur une couche de silice amorphe formée en surface d'un support de silicium. Cependant, un film de graphène obtenu par un tel procédé est polycristallin, les grains de graphène étant séparés par des joints de grains à la surface du substrat.

La présence de joints de grains dans un film de graphène polycristallin porte préjudice aux propriétés électriques du film de graphène. Les porteurs de charge diffusent aux joints de grain, ce qui diminue leur mobilité et augmente la résistance électrique du film de graphène. A titre illustratif, la mobilité des porteurs de charge d'un film de graphène polycristallin obtenu par CVD est comprise entre $10^2$ cm$^2$.V$^{-1}$.s$^{-1}$ et $10^3$ cm$^2$.V$^{-1}$.s$^{-1}$ alors qu'elle est supérieure à $10^5$ cm$^2$.V$^{-1}$.s$^{-1}$ pour du graphène exfolié monocristallin disposé sur un support de silicium.

Le développement de joints de grains limite la production de films de graphène homogènes présentant en outre une faible rugosité de surface. A l'heure actuelle, il est par exemple impossible de produire par CVD des films homogènes et continus d'une longueur supérieure à 100mm sur des supports rigides. Des techniques de production du graphène par la méthode dite « roll to roll » existent pour produire des films de graphène à grande échelle sur un substrat flexible. Cependant, les propriétés de surface du film de graphène sont inhomogènes et sont associées à des contaminations de surface importantes.

Pour sa part, l'article « Growth of Wrinkle-Free Graphene on Texture-Controlled Platinum Films and Thermal-Assisted Transfer of Large Scale Patterned Graphene », J.-K. Choi et al., ACS Nano, Vol. 9, No. 1, pages 679-686, 2015, décrit le dépôt d'un film de graphène sur un substrat en platine texturé d'orientation (200) ou (220) disposé sur un support multicouche SiO$_2$/Si, présentant une mobilité des porteurs de charges de 5500 cm$^2$.V$^{-1}$.s$^{-1}$, et une résistance électrique de 200 $\Omega$.sq, ce qui atteste d'une bonne qualité du graphène. Cependant, avec le procédé décrit dans cet article, il n'est pas montré de fabriquer un film de graphène présentant une taille de grains supérieure à 1 mm, inadaptée aux applications précitées.

Il demeure donc un besoin pour un film de graphène, pouvant être fabriqué en quantités industrielles et présentant des propriétés électriques adaptées aux applications visées dans le domaine de la nanoélectronique et des capteurs biologiques, et notamment présentant une faible teneur en impuretés.

## Résumé de l'invention

L'invention vise à satisfaire ce besoin en proposant un procédé de production d'un film de graphène, le procédé de production comportant les étapes successives suivantes consistant à :

i. disposer d'un substrat comportant une couche de catalyse en contact avec un support autoporteur électriquement isolant, avec

la couche de catalyse comportant, de préférence consistant en, une zone monocristalline de catalyse contenant en masse plus de 99,9% de platine ou plus de 99,9% en masse d'un alliage de platine comportant en masse plus de 50,0 %, de préférence plus de 80,0 % de platine,

le support électriquement isolant s'étendant selon une surface longitudinale et comportant une zone monocristalline électriquement isolante contenant en masse plus de 99,9% d'un oxyde choisi parmi MgO, GeO$_2$, $\alpha$-Al$_2$O$_3$, Pr$_2$O$_3$, $\alpha$-Fe$_2$O$_3$, TiO$_2$, BaTiO$_3$, CeO$_2$, ZrO$_2$, HfO$_2$, Ta$_2$O$_5$, SrO, BaZCO$_3$, SrZrO$_3$, LaAlO$_3$, YAlO$_3$, PrSeO$_3$, CaO, Se$_2$O$_3$, BaO, Lu$_2$O$_3$, La$_2$O$_3$, LaScO$_3$, GdSc$_2$O$_3$, SC$_2$O$_3$, Y$_2$O$_3$, SrZrO$_3$, Y$_3$Al$_5$O$_{12}$, MgAl$_2$O$_4$ et leurs mélanges,

la zone monocristalline de catalyse étant épitaxiée sur la zone monocristalline électriquement isolante, la zone monocristalline électriquement isolante présentant une épaisseur, mesurée selon une direction normale à la surface longitudinale, supérieure à 0,1 mm,

la face de la zone monocristalline de catalyse opposée à la face de la zone monocristalline de catalyse en contact du support présentant une rugosité inférieure à 5,0 nm, puis

ii. former un film de graphène par dépôt épitaxial au contact de la zone monocristalline de catalyse dudit substrat, de préférence au moyen d'un dispositif de dépôt chimique en phase vapeur.

Ainsi, au moyen du procédé de production selon l'invention, un film de graphène monocristallin est obtenu, comportant, de préférence, au moins un grain présentant une rugosité inférieure ou égale à 5,0 nm, de préférence inférieure à 1,0 nm, voire de préférence inférieure à 0,3 nm et une taille supérieure ou égale à 1,0 mm, de préférence supérieure ou égale à 5,0 mm, voire de préférence supérieure ou égale à 30,0 mm. La faible teneur, voire l'absence de joints de grains résulte en des propriétés électriques adaptées aux applications de nanoélectronique et des capteurs biologiques. Notamment, le catalyseur à base de platine favorise, lors de la croissance du film de graphène au cours du dépôt CVD, la formation d'un grain par coalescence de cristaux formés par croissance de germes présentant des orientations identiques et ayant germés en des zones différentes de la couche de catalyse.

Par ailleurs, au sein de la couche de catalyse, le platine favorise la formation d'un film de graphène de faible rugosité et de haute qualité cristalline. Cet effet va à l'encontre d'un préjugé selon lequel un film de graphène de haute qualité ne peut être obtenu qu'en diminuant le désaccord paramétrique entre le métal catalyseur et le carbone hexagonal formant le film de graphène. Par exemple, le platine présente un désaccord paramétrique avec le graphène de 1,14 alors que le nickel, le cuivre et le cobalt qui sont généralement mis en oeuvre dans les substrats de l'art antérieur présentent tous un désaccord paramétrique avec le graphène de 1,04 au plus.

Notamment, comme cela a été décrit dans « nouveaux systèmes magnétiques nanométriques », Chi Vo Van, thèse de l'Université de Grenoble, 2013, la production à grande échelle d'une monocouche de graphène par dépôt chimique en phase vapeur (CVD) était jusqu'à la présente invention, réalisée au moyen d'une couche de catalyse formée de cuivre Cu.

De plus, la pollution du film de graphène par le platine, ou le cas échéant par les autres constituants de l'alliage de platine, peut être réduite au moyen de l'application d'une température de dépôt plus basse et en raison d'un point de fusion du platine plus élevé que pour le cuivre.

Par ailleurs, l'invention concerne un film de graphène, de préférence produit ou susceptible d'être produit par le procédé de production selon l'invention présentant une rugosité inférieure ou égale à 5,0 nm, de préférence inférieure à 1,0 nm, voire de préférence inférieure à 0,3 nm et une taille supérieure ou égale à 1,0 mm, de préférence supérieure ou égale à 5,0 mm, voire de préférence supérieure ou égale à 30,0 mm.

**Définitions**

Un support « autoporteur » présente une rigidité telle qu'il ne peut rompre sous l'effet de son propre poids. Une « couche » nécessite d'être portée et n'est donc pas autoporteuse.

Une « zone monocristalline » est formée d'un matériau cristallin, par exemple un métal ou un oxyde, qui se présente dans ladite zone sous la forme d'un monocristal.

Par l'expression une zone ou une couche « comportant en masse » une teneur exprimée en pourcents d'un constituant, on comprend de manière équivalente que la zone ou la couche respectivement comporte la teneur dudit constituant, exprimée en pourcentages en masse sur la base de la masse de ladite zone ou de la couche respectivement.

Une zone monocristalline « épitaxiée » avec une autre zone monocristalline est obtenue par croissance orientée, du matériau cristallin constituant l'une des zones monocristallines sur le matériau cristallin constituant l'autre zone monocristalline, les dits matériaux cristallins possédant des relations de symétrie cristalline l'un par rapport à l'autre. L'homme du métier sait aisément caractériser et reconnaître deux zones monocristallines épitaxiées l'une avec l'autre.

Lorsqu'une première zone monocristalline constituée d'un premier matériau est épitaxiée avec une deuxième zone monocristalline constituée d'un deuxième matériau, l'homme du métier sait aisément déterminer, d'une part la relation d'épitaxie entre les premier et deuxième matériaux constitutifs respectivement des première et deuxième zones et, d'autre part, dans ladite relation d'épitaxie entre lesdits matériaux, le « désaccord paramétrique » $\Delta$ entre lesdits premier et deuxième matériaux.

Le désaccord paramétrique $\Delta$ entre le premier matériau et le deuxième matériau est défini selon l'équation de formule (1) suivante :

$$\Delta = \frac{a_1 - a_2}{a_2} \ (1)$$

dans laquelle $a_1$ et $a_2$ sont des paramètres de maille du premier matériau et du deuxième matériau dans la relation d'épitaxie. A titre illustratif, par exemple le premier matériau est le saphir $\alpha\text{-Al}_2\text{O}_3$ et le deuxième matériau est le silicium cristallin. $\alpha\text{-Al}_2\text{O}_3$ est de structure hexagonale et présente un paramètre de la maille de l'hexagone du plan basal $d_{(1000)}^{\alpha-\text{Al}_2\text{O}_3}$, égal à 4,758 Å. Le silicium cristallin est de structure diamant et présente un paramètre de la maille diamant $d_{(100)}^{Si}$, correspondant au côté de l'arrête de la maille diamant, égal à 5,404 Å. Dans la relation d'épitaxie, un axe (100) de la maille diamant du silicium est parallèle à l'axe (0001) correspondant à l'axe $\vec{c}$ de la maille hexagonale de $\alpha\text{-Al}_2\text{O}_3$ et un axe

(010) du silicium est parallèle à un axe (1000) de $\alpha$-Al$_2$O$_3$. Le paramètre de maille du silicium dans la relation d'épitaxie $a_{si}$ est égal à la distance $d^{Si}_{(100)}$ entre deux atomes de silicium selon la direction (100) du silicium et le paramètre de maille de $\alpha$-Al$_2$O$_3$ dans la relation d'épitaxie $a_\alpha$-Al$_2$O$_3$ est égal à la distance $d^{\alpha-Al_2O_3}_{(1000)}$. Ainsi, $a_\alpha$-Al$_2$O$_3$ = 4,758 Å et $a_{si}$ = 5,404 Å. Dans la relation d'épitaxie entre le silicium cristallin et $\alpha$-Al$_2$O$_3$. le désaccord paramétrique de $\alpha$-Al$_2$O$_3$ avec le silicium cristallin est donc de -12,0%.

La « taille » d'un grain est mesurée par MEB, acronyme de « Microscopie Electronique à Balayage » ou par DF-TEM, acronyme anglais de « Dark Field Transmission Electron Microscopy ».

La « rugosité » de surface d'une couche ou d'un grain est mesurée par AFM (acronyme anglais de « Atomic Force Microscopy ») au moyen du dispositif de dénomination commerciale BRUCKER « AFM Dimension 1 ». La mesure de rugosité peut être effectuée en mettant en oeuvre la méthodologie « mode tapping » sur une zone d'analyse X/Y de l'échantillon utilisé, par exemple une couche, un support ou un film, présentant une aire de 1 $\mu$m$^2$. Le traitement des données acquises sur la zone peut être effectué au moyen du Logiciel « Nanoscope Analysis » version 1.5.

## Figures

D'autres caractéristiques et avantages de l'invention apparaîtront encore à la lecture de la description détaillée qui va suivre et à la lecture du dessin annexé dans lequel :

- la figure 1 représente un substrat pour la mise en oeuvre du procédé de production selon l'invention, et
- la figure 2 représente un spectre Raman d'un film de graphène obtenu par dépôt épitaxial sur une couche monocristalline de platine (001) d'un substrat, ladite couche étant portée par un support monocristallin de MgO (001).

Dans le dessin annexé, les proportions réelles des divers éléments constitutifs ou leurs espacements n'ont pas été toujours été respectées dans un souci de clarté. Par ailleurs, certains éléments peuvent ne pas avoir été représentés en contact les uns avec les autres dans un souci de clarté, alors qu'ils le sont en pratique.

## Description détaillée

On dispose d'un substrat 5 comportant un empilement 10 contenant une couche de catalyse 15 superposée à un support électriquement isolant 20. Le support électriquement isolant comporte une zone monocristalline électriquement isolante. Par exemple, on peut choisir le support électriquement isolant parmi ceux disponibles dans le commerce.

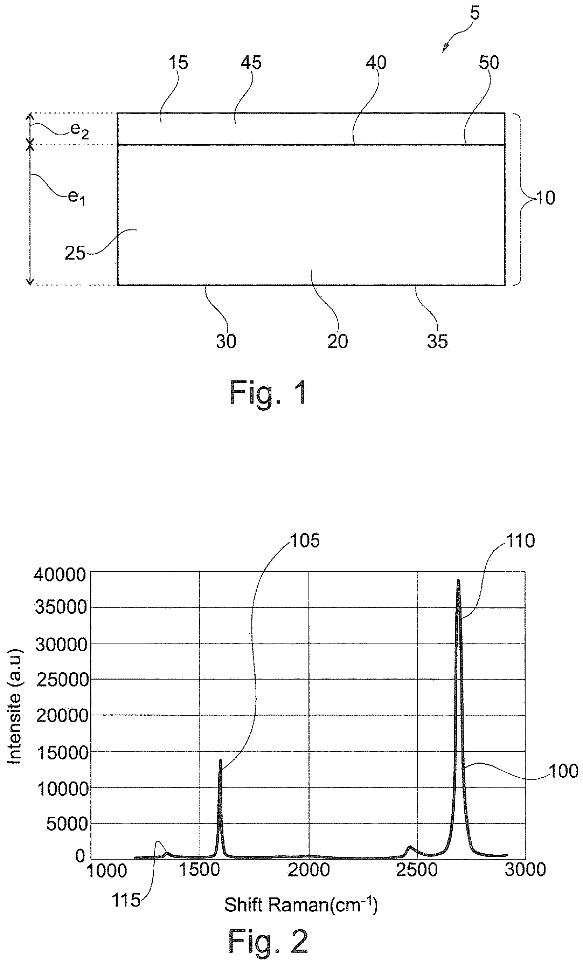

La couche de catalyse est partiellement ou totalement, comme illustré sur la figure 1, au contact du support.

Le support 20 comporte une zone monocristalline électriquement isolante 25.

De préférence, la zone monocristalline électriquement isolante s'étend selon une surface longitudinale 30 courbe ou de préférence plane, la longueur et/ou la largeur de la zone monocristalline électriquement isolante étant de préférence supérieure ou égale à 20 mm, de préférence supérieure ou égale à 50 mm, voire mieux supérieure ou égale à 200 mm.

De préférence, l'épaisseur $e_1$ de la zone monocristalline électriquement isolante est supérieure à 0,1 mm, de préférence supérieure à 0,5 mm, notamment lorsque le support est formé de $\alpha$-Al$_2$O$_3$.

La zone monocristalline électriquement isolante peut représenter au moins 50%, de préférence au moins 70%, de préférence au moins 90%, de préférence au moins 99%, de préférence au moins 99,9% de la masse du support. En particulier, comme cela est illustré sur la figure 1, le support peut consister en la zone monocristalline électriquement isolante. En variante, le support peut comporter une zone polycristalline, par exemple entourant partiellement la zone monocristalline électriquement isolante. La zone monocristalline électriquement isolante peut s'étendre sur toute l'épaisseur du support.

Le support peut présenter une forme variée. De préférence, il se présente sous la forme d'une plaquette présentant deux faces 35,40 parallèles séparées par l'épaisseur $e_1$ du support. La plaquette peut notamment présenter une forme de pavé droit ou circulaire.

De préférence, la longueur du support est comprise entre 20 mm et 200 mm et/ou la largeur du support est comprise entre 20 mm et 200 mm.

De préférence, la rugosité de la face 40 de la zone monocristalline électriquement isolante située à l'interface avec la zone monocristalline de catalyse est inférieure à 0,3 nm. Ainsi, au cours de la fabrication du substrat, la formation d'une couche de catalyse de haute cristallinité est favorisée.

De préférence, l'oxyde est choisi parmi MgO, $\alpha$-Al$_2$O$_3$, TiO$_2$, BaTiO$_3$, LaAlO$_3$, YAlO$_3$, Y$_3$Al$_5$O$_{12}$, MgAl$_2$O$_4$, SrTiO$_3$ et leurs mélanges. De préférence, l'oxyde est choisi parmi $\alpha$-Al$_2$O$_3$, MgO et SrTiO$_3$.

De préférence, l'oxyde présente une constante diélectrique supérieure à 4,0. Un tel oxyde est généralement dénommé « high-K ».

Lorsque l'oxyde présente une symétrie cristalline cubique, la zone monocristalline électriquement isolante peut être orientée selon l'axe (001) de la maille cristalline de l'oxyde, l'axe étant sensiblement parallèle à une normale à une interface entre la zone monocristalline électriquement isolante et la zone monocristalline de catalyse.

Lorsque l'oxyde présente une symétrie cristalline hexagonale, et est notamment $\alpha\text{-Al}_2\text{O}_3$. la zone monocristalline électriquement isolante peut être orientée selon l'axe (0001) étant l'axe $\vec{c}$ de la maille hexagonale de l'oxyde, l'axe étant sensiblement parallèle à une normale à une interface entre la zone monocristalline électriquement isolante et la zone monocristalline de catalyse.

Par « sensiblement parallèle », on entend que l'angle entre l'axe et la normale, en valeur absolue, est inférieur à 1°.

Outre l'oxyde, la zone monocristalline électriquement isolante peut comporter un dopant ou une impureté de l'oxyde, par exemple du platine. De préférence, la teneur massique en dopant et/ou en impureté de la zone monocristalline électriquement isolante est inférieure ou égale à 0,01 %.

En ce qui concerne la couche de catalyse, elle peut recouvrir partiellement ou intégralement le support électriquement isolant.

De préférence, la couche de catalyse est d'épaisseur $e_2$ constante. De préférence, la couche de catalyse présente une épaisseur inférieure ou égale à 500 nm. Avantageusement, une couche de catalyse d'une telle épaisseur présente une faible rugosité, une bonne qualité cristalline et un paramètre de maille adapté par rapport au graphène d'une part et d'autre part par rapport à l'oxyde.

L'épaisseur $e_2$ de la couche de catalyse peut être d'au moins 50 nm. De préférence, la rugosité de la face de la zone monocristalline de catalyse opposée à la face de ladite zone en contact du support électriquement isolant est inférieure à 3,0 nm, de préférence inférieure à 1,0 nm, voire de préférence inférieure à 0,5 nm, voire de préférence inférieure à 0,3 nm.

Par ailleurs, la couche de catalyse présente de préférence une longueur et/ou une largeur inférieures ou égales à la longueur et/ou la largeur respectivement du support.

De préférence, la zone monocristalline de catalyse 45 s'étend selon une surface 50 courbe ou de préférence plane, la longueur et/ou la largeur de la zone monocristalline de catalyse étant supérieure à 20 mm, de préférence supérieure à 50 mm, voire supérieure ou égale à 150 mm.

De préférence, le platine ou l'alliage de platine présente un désaccord paramétrique avec l'oxyde, exprimé en valeur absolue, inférieur à 15 %. De cette façon, la croissance épitaxiale de la zone monocristalline de catalyse sur la zone monocristalline électriquement isolante est favorisée et la densité de défauts cristallins dans la zone monocristalline de catalyse est réduite.

De préférence, l'alliage de platine comporte un métal de transition choisi parmi fer, l'or, le palladium, le rhodium, le rhénium, le cobalt, le nickel, le cuivre et leurs alliages. Plus préférentiellement, le métal de transition est choisi parmi le cuivre, le cobalt, le nickel et leurs alliages. En particulier, la somme totale des teneurs massiques du métal de transition et du platine peut être supérieure à 50 %, de préférence supérieure à 80 %, voire supérieure à 95 %, en pourcentages en masse sur la base de la masse de l'alliage de platine.

Un alliage de platine préféré comporte du cuivre et/ou du nickel et/ou du cobalt. Le désaccord paramétrique de l'alliage avec le graphène peut ainsi être optimisé pour améliorer la qualité du film de graphène.

En particulier, la teneur en masse en platine de l'alliage de platine peut être supérieure à 50,0 %, de préférence supérieure à 80,0 %, voire supérieure à 90,0%, voire supérieure à 95,0 %.

Par ailleurs, la zone monocristalline de catalyse est de préférence orientée selon l'axe (001) ou l'axe (111), l'axe étant sensiblement parallèle à une normale à une des faces de la couche de catalyse.

Selon une variante préférée :

- la zone monocristalline électriquement isolante représente de préférence plus de 99% de la masse du support électriquement isolant, et contient en masse plus de 99,9% de $\alpha\text{-Al}_2\text{O}_3$, l'axe d'orientation de la zone monocristalline électriquement isolante est l'axe $\vec{c}$ (0001) de la maille hexagonale et est sensiblement parallèle à une normale d'au moins une d'une des faces du support électriquement isolant, et

- la zone monocristalline de catalyse représente de préférence plus de 99% de la masse de la couche de catalyse, et contient en masse plus de 99,9% de platine, l'axe d'orientation de la zone monocristalline de catalyse est l'axe (111) de la maille cubique du platine et est sensiblement parallèle à une normale à au moins une des faces de la couche de catalyse.

Le substrat selon l'invention décrit ci-dessus peut être fabriqué en mettant en oeuvre la méthode Czochalski Kyropoulos Stepanov.

Le film de graphène selon l'invention est de préférence produit au moyen du procédé de production selon l'invention.

Le procédé de production peut notamment comprendre une étape i') intermédiaire aux étapes i) et ii) consistant à nettoyer le substrat, de préférence sous un flux de dihydrogène $H_2$, par exemple pour éliminer les résidus de carbone provenant de précurseurs du platine ou de l'alliage de platine mis en oeuvre lors de la fabrication de la zone monocristalline de catalyse.

A l'étape ii), on forme un film de graphène par dépôt épitaxial au contact de la zone monocristalline de catalyse du substrat.

De préférence la formation du film de graphène est effectuée par CVD au moyen d'un dispositif de dépôt chimique en phase vapeur.

De préférence, à l'étape ii), le substrat est disposé au sein de l'enceinte du dispositif CVD, et est de préférence chauffé à une température comprise entre 500 °C et 1100°C, par exemple égale à 800°C. De préférence, la formation du film de graphène résulte de la décomposition catalytique d'un gaz carboné, de préférence d'un alcane, plus préférentiellement de méthane CH$_4$, par exemple de propylène, d'acétylène benzène ou de pyridine en présence d'un catalyseur métallique, par exemple le platine. De préférence, à l'étape ii), un mélange de méthane et de dihydrogène est injecté dans l'enceinte. De préférence, le rapport du débit massique de méthane sur le débit massique 5 slm (standard litre par minute) de dihydrogène est inférieur ou égal à 1/100, de préférence inférieur ou égal à 1/1000. La densité de nucléation de germes de graphène en surface de la zone monocristalline de catalyse est ainsi réduite, limitant le nombre de grains dans le film de graphène.

Le procédé de production peut en outre comprendre une étape iii), successive à l'étape ii) au cours duquel le substrat recouvert du film de graphène est refroidi jusqu'à ce que la température du substrat recouvert du film de graphène soit inférieur à 30°C. De préférence, à l'étape iii), le refroidissement est effectué sous un flux gazeux de di-hydrogène. En particulier, la température de refroidissement peut être inférieure 1°C.s$^{-1}$.

De plus, le procédé de production peut comporter une étape iv), successive à l'étape ii) et le cas échéant à l'étape iii), consistant à décoller le film de graphène du substrat, puis à recouvrir un support récepteur dudit film de graphène.

## Exemple

L'invention est maintenant illustrée au moyen de l'exemple non limitatif décrit ci-dessous.

Un support monocristallin de MgO est introduit dans l'enceinte d'un dispositif PVD HT.

Le support provient est commercialisé par la -gmbh société crystal et présente une forme de pavé droit dont les longueur, largeur et épaisseur sont égales à 1 cm, 1 cm et 0,5 mm. Le support monocristallin est orienté selon un axe (001) de la maille cristalline MgO parallèle à l'épaisseur de la plaque. La face du support destinée à être recouverte d'une couche monocristalline de platine est normale à l'épaisseur et présente une rugosité inférieure à 1,0 nm. Une couche monocristalline de catalyse constituée de platine est formée sur ladite face. Elle présente une épaisseur de 50 nm.

Le substrat est ensuite nettoyé au moyen d'un flux de dihydrogène puis est disposé dans l'enceinte d'un dispositif de dépôt CVD. Il est chauffé à 800°C sous une atmosphère de dihydrogène à 5 slm (standard litre par minute). Un flux de méthane est injecté dans l'enceinte et un film de graphène est formé et est épitaxié sur la couche de catalyse du substrat par décomposition catalytique du méthane. Le rapport du débit massique de méthane sur le débit massique de dihydrogène est fixé à 1/1000. La durée du dépôt est de 2h. Le substrat recouvert du film est ensuite refroidi sous atmosphère de dihydrogène jusqu'à température ambiante.

Le film de graphène ainsi obtenu comporte un grain présentant une taille supérieure à 1,0 mm, une épaisseur comprise entre 0,2 nm et 1 nm et une rugosité moyenne de surface inférieure à 3,0 nm.

La résistance carré du film de graphène, mesurée par la méthode des quatre pointes est inférieure à 350 Ohm/square et la mobilité des porteurs de charges, mesurée par effet Hall inférieure a 5x10$^4$ cm$^2$/Vs.

L'analyse du spectre Raman 100 du film de graphène représenté sur la figure 2 montre que le rapport de l'intensité (en ordonnée) du pic G 105 sur l'intensité du pic 2D 110 est d'environ 0,35, ce qui indique que le film de graphène présente une haute cristallinité. Les spectres Raman ont été enregistrés dans la géométrie de rétrodiffusion à l'aide d'un appareil Renishaw Spectromètre Raman. La lumière a été focalisée sur la surface de l'échantillon grâce à une lumière 100 x(0,85 NA-ouverture numérique) avec un diamètre de spot d'environ 0,7 $\mu$m. La longueur d'onde d'excitation était de 532 nm avec une puissance laser typique de 1 mW. Par ailleurs, le rapport de l'intensité du pic D 115 sur l'intensité du pic G est d'environ 0,06 indique que le film comporte en outre une faible teneur en défauts dans le cristal de graphène et présente une haute qualité cristallinité.

Bien évidemment, l'invention n'est pas limitée aux modes de réalisation du substrat ni aux modes de mise en oeuvre du procédé de fabrication et du procédé de production qui y sont décrits.

## Revendications

1.  Procédé de production d'un film de graphène, le procédé de production comportant les étapes successives suivantes consistant à :

    i) disposer d'un substrat (5) comportant une couche de catalyse (15) en contact avec un support (20) autoporteur électriquement isolant, avec la couche de catalyse comportant, de préférence consistant en, une zone monocristalline de catalyse (45) contenant en masse plus de 99,9% de platine ou plus de 99,9% en masse d'un alliage de platine comportant en masse plus de 50,0 %, de préférence plus de 80,0 % de platine, le support électriquement isolant s'étendant selon une surface longitudinale (30) et comportant une zone monocristalline électriquement isolante (25) contenant en masse plus de 99,9% d'un oxyde choisi parmi MgO, GeO$_2$, $\alpha$-Al$_2$O$_3$, Pr$_2$O$_3$, $\alpha$-Fe$_2$O$_3$, TiO$_2$, BaTiO$_3$, CeO$_2$, ZrO$_2$, HfO$_2$, Ta$_2$O$_5$, SrO, BaZrO$_3$, SrZrO$_3$, LaAlO$_3$, YAlO$_3$, PrSeO$_3$, CaO, Se$_2$O$_3$, BaO, Lu$_2$O$_3$, La$_2$O$_3$, LaScO$_3$, GdSc$_2$O$_3$, SC$_2$O$_3$, Y$_2$O$_3$, SrZrO$_3$, Y$_3$Al$_5$O$_{12}$, MgAl$_2$O$_4$ et leurs mélanges, la zone mono cristalline de catalyse étant épitaxiée sur la zone mono cristalline électriquement isolante,

la zone monocristalline électriquement isolante présentant une épaisseur ($e_1$), mesurée selon une direction normale à la surface longitudinale, supérieure à 0,1 mm, la face de la zone monocristalline de catalyse opposée à la face de la zone monocristalline de catalyse en contact du support présentant une rugosité inférieure à 5,0 nm, puis

ii) former un film de graphène par dépôt épitaxial au contact de la zone monocristalline de catalyse dudit substrat, de préférence au moyen d'un dispositif de dépôt chimique en phase vapeur.

**2.** Procédé selon la revendication 1, dans lequel la face de la zone monocristalline de catalyse opposée à la face de la zone monocristalline de catalyse en contact du support présente une rugosité inférieure à 3,0 nm, de préférence inférieure à 1,0 nm, voire de préférence inférieure à 0,3 nm.

**3.** Procédé selon l'une quelconque des revendications 1 et 2, dans lequel l'alliage de platine comporte en outre un métal de transition choisi parmi le fer, l'or, le palladium, le rhodium, le rhénium, le cobalt, le nickel, le cuivre et leurs alliages.

**4.** Procédé selon l'une quelconque des revendications précédentes, dans lequel la somme totale des teneurs massiques du métal de transition et du platine est supérieure à 80 %, de préférence supérieure à 95 %, en pourcentages en masse sur la base de la masse de l'alliage de platine.

**5.** Procédé selon l'une quelconque des revendications précédentes, dans lequel l'alliage de platine comporte en masse plus de 90,0 % de platine.

**6.** Procédé selon l'une quelconque des revendications précédentes, dans lequel la couche de catalyse présente une épaisseur inférieure ou égale à 500 nm.

**7.** Procédé selon l'une quelconque des revendications précédentes, dans lequel la zone monocristalline de catalyse est orientée selon l'axe (001) ou l'axe (111), l'axe étant sensiblement parallèle à une normale à une des faces de la couche de catalyse.

**8.** Procédé selon l'une quelconque des revendications précédentes, dans lequel l'oxyde est $\alpha$-$Al_2O_3$ ou MgO ou $SrTiO_3$.

**9.** Procédé selon la revendication précédente, dans lequel

- l'oxyde est MgO et la zone monocristalline électriquement isolante est orientée selon l'axe (111), l'axe étant parallèle à une normale à une des faces de la couche de catalyse, ou
- l'oxyde est $\alpha$-$Al_2O_3$ et la zone monocristalline électriquement isolante est orientée selon l'axe (0001) étant l'axe $\vec{c}$ de la structure hexagonale, l'axe étant parallèle à une des faces de la couche de catalyse.

Fig. 1

Fig. 2

Europäisches
Patentamt

European
Patent Office

Office européen
des brevets

# RAPPORT DE RECHERCHE EUROPEENNE

Numéro de la demande

EP 17 20 9123

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2012/196074 A1 (AGO HIROKI [JP] ET AL) 2 août 2012 (2012-08-02) * alinéa [0016] - alinéa [0031] * * alinéa [0087] - alinéa [0102] * * alinéa [0108] * * alinéa [0129] * * alinéa [0142] - alinéa [0143] * ----- | 1-9 | INV. H01L21/02 H01L29/16 C01B32/186 C01B32/188 |
| X | KR 2013 0020351 A (KOREA ELECTROTECH RES INST [KR]) 27 février 2013 (2013-02-27) * alinéa [0002] * * alinéa [0011] - alinéa [0073] * ----- | 1-9 | |
| A | KR 2013 0014182 A (SAMSUNG ELECTRONICS CO LTD [KR]; UNIV SUNGKYUNKWAN RES & BUS [KR]) 7 février 2013 (2013-02-07) * alinéa [0035] - alinéa [0039] * ----- | 1-9 | |

**DOMAINES TECHNIQUES RECHERCHES (IPC)**

H01L
C01B

Le présent rapport a été établi pour toutes les revendications

| Lieu de la recherche | Date d'achèvement de la recherche | Examinateur |
|---|---|---|
| Munich | 11 avril 2018 | Bruckmayer, Manfred |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 17 20 9123

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-04-2018

| Document brevet cité au rapport de recherche | Date de publication | Membre(s) de la famille de brevet(s) | Date de publication |
|---|---|---|---|
| US 2012196074 A1 | 02-08-2012 | JP 5641484 B2<br>JP WO2011025045 A1<br>US 2012196074 A1<br>WO 2011025045 A1 | 17-12-2014<br>31-01-2013<br>02-08-2012<br>03-03-2011 |
| KR 20130020351 A | 27-02-2013 | AUCUN | |
| KR 20130014182 A | 07-02-2013 | AUCUN | |

## RÉFÉRENCES CITÉES DANS LA DESCRIPTION

**Documents brevets cités dans la description**

- CN 104045079 A1

- US 20130288464 A1

**Littérature non-brevet citée dans la description**

- **J.-K. CHOI et al.** Growth of Wrinkle-Free Graphene on Texture-Controlled Platinum Films and Thermal-Assisted Transfer of Large Scale Patterned Graphene. *ACS Nano,* 2015, vol. 9 (1), 679-686

- **CHI VO VAN.** nouveaux systèmes magnétiques nanométriques. *thèse de l'Université de Grenoble,* 2013